Europäisches Patentamt

European Patent Office

Office européen des brevets

(11) Publication number: **0 166 208**
**B1**

(12) **EUROPEAN PATENT SPECIFICATION**

(45) Date of publication of patent specification: **28.03.90**

(51) Int. Cl.⁵: **H 01 L 29/78, H 01 L 29/62**

(21) Application number: **85106320.6**

(22) Date of filing: **23.05.85**

(54) Charge storage structure for nonvolatile memory.

(30) Priority: **25.06.84 US 624432**

(43) Date of publication of application:
**02.01.86 Bulletin 86/01**

(45) Publication of the grant of the patent:
**28.03.90 Bulletin 90/13**

(84) Designated Contracting States:
**DE FR GB**

(56) References cited:
EP-A-0 034 653
EP-A-0 040 701
EP-A-0 082 936
EP-A-0 105 802
US-A-3 649 884

PATENT ABSTRACTS OF JAPAN, vol. 6, no. 206
(P-149)1084r, 19th October 1982; & JP - A - 57
111 884

(73) Proprietor: **International Business Machines
Corporation
Old Orchard Road
Armonk, N.Y. 10504 (US)**

(72) Inventor: **Wolf, Hans Peter
Frohalpstrasse 60
CH-8038 Zurich (CH)**
Inventor: **Young, Donald Reeder
14 Briarbrook Road
Ossining New York 10562 (US)**

(74) Representative: **Blakemore, Frederick Norman
et al
IBM United Kingdom Limited Intellectual
Property Department Hursley Park
Winchester Hampshire SO21 2JN (GB)**

Courier Press, Leamington Spa, England.

## Description

Background

This invention relates to a memory device comprising a charge storage structure built utilizing silicon-rich technology.

Floating gate storage FET devices are well known in the technology where a conductor, usually Si, is embedded in an insulator layer. Such memory elements store information and allow for information modification and erasure. Some floating gate devices have employed Si-rich layers as conductors for charge injection enhancement, but cannot store discrete charges in the Si-rich layers due to the presence of a conductive layer adjacent to the Si-rich region.

FET structure used for such memory elements is typified by U.S. Patent No. 3,649,884 which utilizes a field effect transistor provided with a gate assembly. The gate assembly therein comprises a sandwich of a layer of $SiO_2$ with excess Si disposed between two insulating films of appropriate thickness for the entrapment of charge carriers in the silicon-rich $SiO_2$ layer. This triple layer is disposed between the gate electrode and the substrate. This device requires a thin, 30—40 Å, insulator on the bottom of the Si-rich layer otherwise tunneling cannot occur. However, charge leakage problems occur due to the thinness of the insulator.

Another example of an electrically alterable floating gate memory device is disclosed in U.S. Patent 4,253,106. A silicon-rich oxide layer is disposed between the control gate and the floating gate.

A difficulty in prior art floating gate systems using embedded conductors is charge leakage if the structure is defective. Since the conductor can be considered an entity, charge tends to leak off eventually resulting in complete discharge and loss of the stored information. It is of course desired to have a memory device programmed to retain the information over an extended period of time until reprogrammed without loss of charge.

Another of the difficulties of such electrically erasable programmable read only memory (EEPROM) devices is a need for significant amounts of chip area due to the floating gate structure.

Summary of the invention

This invention departs from the prior art by using a trap structure as the charge retention mechanism instead of a floating gate memory structure. The invention eliminates the problem of leakage since if a defect exists only traps that are locally affected will be depleted. The charge storage structure employed by this invention employs Si-rich $SiO_2$ which is effectively an insulator at low fields but a conductor at high fields, i.e., for programming the device. However, the Si-rich $SiO_2$ used in the device of this invention provides traps to store charges.

In accordance with the present invention, a new charge storage structure is defined which is classified as an intermediate between prior MNOS devices and prior floating gate devices. The storage structure comprises four layers disposed between two electrodes. The lower electrode is a Si substrate. The upper electrode is doped polysilicon or metal such as aluminium. Alternative oxide and Si-rich oxide layers define the four layer structure. In accordance with the present invention, the upper Si-rich layer acts as an enhanced Fowler-Nordheim injector. The second, or middle, Si-rich layer which is sandwiched between two oxide layers also acts as an injector at the high fields used for device programming. Importantly, this middle Si-rich layer is capable of storing a positive or negative charge because the Si particles in the oxide matrix act as deep electron traps. The two oxide layers act as insulators to prevent leakage at normal device operating conditions.

As will be set forth herein, this new charge storage structure may be used in a programmable device. An appropriate circuit is similar to the circuit for a MNOS device, with the MNOS gate replaced by a structure in accordance with the present invention. However, the steps of programming, reading, and erasing are done in a manner corresponding to technology associated with MNOS cells.

This invention will be described in greater detail by referring to the attached accompanying drawing and the description of the preferred embodiments which follow.

Brief description of the drawing

Figure 1 is a schematic cross-sectional view of charge storage structure in accordance with the present invention; and

Figure 2 is a schematic cross-sectional view of an electrically erasable programmable read-only memory utilizing the charge storage structure of Figure 1.

Description of the preferred embodiments

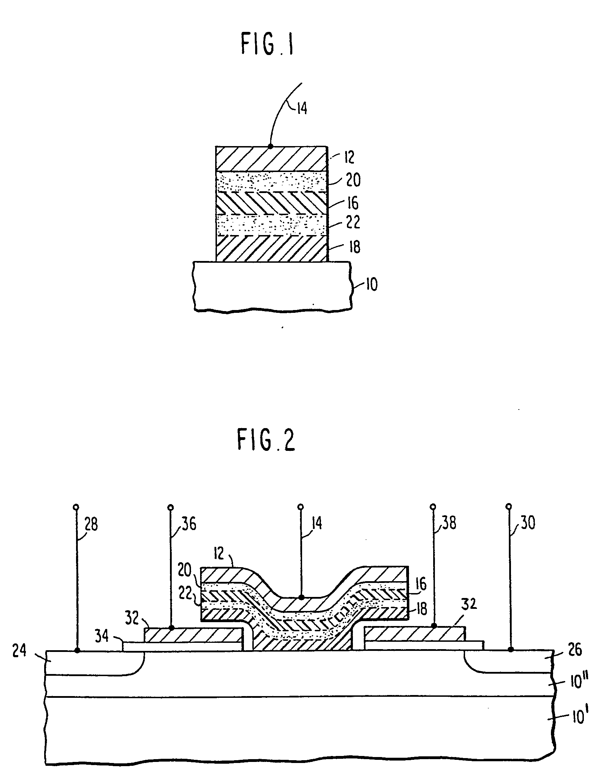

Referring now to Fig. 1, a schematic cross-section of a charge storage structure of this invention is depicted. The structure essentially comprises four layers sandwiched between two electrodes. The lower layer 10 is a silicon substrate. The upper electrode 12 is doped polysilicon or a metallic conductor such as aluminium having shown schematically a metalization lead 14. Sandwiched between the substrate and the upper electrode is a four layer structure comprising two $SiO_2$ layers 16 and 18 and two Si-rich oxide layers 20 and 22. Si-rich oxides are known, for example, DiMaria et al, "Electrically-Alterable Read-Only-Memory Using Si-Rich $SiO_2$ Injectors and a Floating Polycristalline Silicon Storage Layer", J. Appl. Phys., 52, 4825 (1981). In accordance with the present invention, thickness of layers 16, 18, 20 and 22 is in the range of 8—30 nm (80—300 Å). The thickness of each layer may vary as a function of fabrication parameters for optimizing a particular device to a particular application.

The upper Si-rich layer 20 acts as an enhanced Fowler-Nordheim injector (See "Electron Emission in Intense Electric Fields", Proc. Roy. Soc. (London) 119, 173 (1928)). By enhanced Fowler-Nordheim injection is meant that injection takes place at a lower applied field by virtue of the excess Si in the $SiO_2$. The middle Si-rich layer 22 is sandwiched between the $SiO_2$ layers 16 and 18. It also acts as an injector but importantly is capable of storing a positive or negative charge. This phenomenon occurs because the Si particles in the oxide matrix, shown in Figure 1, acts as deep traps.

EP—A—0 034 653 shows a DEIS structure such that $SiO_2$: Si—$SiO_2$—$SiO_2$: Si layers are provided between a control gate and a floating gate or trapping layer.

In accordance with the structure of Figure 1, two charge storage operations are perceived; charging to a positive state and discharging to an approximately neutral state. These two charge storage operations occur as follows.

(a) charging to a positive state:

A positive voltage is applied to the upper electrode 12. Electrons move from the storage layer (22) by Fowler-Nordheim tunneling. The flat Si—$SiO_2$ interface which exists between layers 10 and 18 results in bad injection efficiency and therefore at this field no electrons are injected from the bottom surface 10. When the external voltage is removed, the middle Si-rich layer 22 is positively charged.

(b) discharging to an approximately neutral state:

A positive voltage is applied to the bottom electrode 10. Electrons are injected from the top injector 12 into the middle Si-rich layer 22 until an approximately neutral state is achieved. Then, the field in the lower $SiO_2$ layer 18 becomes as large as that in the upper $SiO_2$ layer 16 so that the middle Si-rich layer 22 begins to inject electrons into the Si substrate 10. This results in an approximately neutral state in the middle Si-rich layer 22. As a variation of this technique of discharging to an approximately neutral state, the positive voltage on the bottom electrode 10 could be replaced by utilizing a negative voltage at the top electrode 12.

Thus, in these two charge storage operations, it can be seen that the upper Si-rich layer 20 acts as a Fowler-Nordheim injector and the middle Si-rich layer while also acting as an injector stores positive or negative charges. This basic structure can be utilized in the context of a memory cell.

Fig. 2 shows the use of the charged storage structure of Figure 1 in the context of an electronically erasable programmable read only memory (EEPROM). As is well known, the EEPROM memory cell is a three gate structure, for example, as described in Lancaster et al, "A 5-V-Only EEPROM with Internal Programs/Erase Control", 1983 IEEE Solid State Circuits Conference, Digest of Technical Papers, pp. 164—165. Such memory cells typically use metal-$Si_3N_4$—$SiO_2$—Si gates. These structures (See, Sze, "Physics of Semiconductor Devices", John Wiley, New York, 1981, pp. 496—506) are replaced with the charged storage structure of the present invention. As shown in Figure 2, the EEPROM structure utilizes the charge storage structure of Figure 1, that is $SiO_2$ layers 16 and 18 with Si-rich $SiO_2$ layers 20 and 22. Electrode 14 coupling the doped polysilicon layer 12 forms a gate. EEPROM structure is constructed on a silicon substrate comprising typically a first layer 10' of n-silicon having deposited thereon a second layer 10'' of silicon of an opposite conductivity type. By conventional semiconductor techniques, a source and drain region 24 and 26 are placed in the layer 10''. Appropriate electrodes 28 and 30 are used to provide contacts to the source and drain regions. It will be appreciated that the remaining portion of this FET structure is completed by having polycrystalline silicon gate layers 32, on top of insulating layers 34, such as a thermal $SiO_2$. Appropriate leads 36 and 38 are used to make contact to the gates. If the structure is built on single crystalline Si, then the first oxide layer 18 can be obtained by conventional oxidation techniques. The remaining three layers are then built by CVD.

Erasing, programming and reading are done in a manner corresponding to known MNOS cells. The structure of Figure 2 has no charge in the storage layer in its erase state. The Si layer 10'' below the storage gate is in depletion. In the programmed state with positive charge in the storage layer 22, the Si layer 10'' is in inversion (i.e., with zero voltage in the gate).

The EEPROM structure of Figure 2 offers better controllability than conventional MNOS devices. The injection efficiency of the charge storage structure can be adjusted by the Si content in the Si-rich oxide layers 20 and 22. The amount of trapping in the storage layer 22 can be adjusted by its thickness and its Si content. It will be appreciated that the programming voltages required are functions of the thicknesses of the oxide layers.

This invention is also advantageous over floating gate structures since it eliminates the requirement for ultrathin insulators. Also the problem of optimizing device switching speed as a function of charge retention common in floating gate structures is avoided due to the charge retention ability of the middle Si-rich layer.

The fabrication of the structure shown in Figure 2 can be done utilizing chemical vapor deposition (CVD) in a manner known for double electron injector structures. DiMaria et al, *supra*, identify such DEIS configurations, including an electrode and Si-layer sandwich including two silicon-rich dioxide layers separated by a single $SiO_2$ layer. Manufacturing

techniques of that 3-layer structure are applicable for the 4-layer structure. Efficiencies occur because the entire 4-layer structure can be fabricated in a single run by changing the gas mixtures at appropriate points in the run.

While this invention, has been described in the context of a storage gate for an EEPROM, it is apparent that it may be employed in other nonvolatile memories.

## Claims

1. A charge storage structure comprising:
a silicon substrate (10);
a four layer sandwich on said silicon substrate layer comprising in order, a first silicon dioxide layer (18), a first silicon-rich silicon dioxide layer (22), a second silicon dioxide layer (16) and a second silicon-rich silicon dioxide layer (20), said first silicon-rich silicon dioxide layer (22), acting as an enhanced Fowler-Nordheim injector and also storing charges as a deep trap region and the second silicon-rich silicon dioxide layer (20) acting as an enhanced Fowler-Nordheim injector; and
a conductive layer (12) disposed on said four layer sandwich.

2. The charge storage structure of claim 1 further comprising separate electrode means (14) attached to said substrate and said conductive layer.

3. The charge storage structure of claim 1 wherein said conductive layer is doped polysilicon.

4. The charge storage structure of claim 1 wherein said conductive layer is a metal such as aluminium.

5. The charge storage structure of claim 1 wherein each layer of said four layer sandwich has a thickness in the range of 8—30 nm.

6. The charge storage structure of claim 1 further comprising source (24) and drain (26) regions disposed in substrate, said four layer sandwich and said conductive layer positioned between said source and drain as a storage region thereby defining a storage device.

7. The charge storage structure of claim 6 further comprising first and second gates (32) respectively placed between said source and said storage region and said storage region and said drain.

## Patentansprüche

1. Ladungsspeicherstruktur, enthaltend
ein Silikonsubstrat (10);
eine vierschichtige Sandwichplatte auf der genannten Substratschicht, enthaltend, der Reihenfolge nach, eine erste Silikondioxydschicht (18), eine erste silikonreiche Silikondioxydschicht (22), eine zweite Silikondioxydschicht (16) und eine zweite silikonreiche Silikondioxydschicht (20), wobei die genannte erste silikonreiche Silikondioxydschicht (22) als ein verbesserter Fowler-Nordheim-Injektor wirkt und ebenfalls als ein tiefer Störstellenbereich Ladungen speichert und die zweite silikonreiche Silikondioxydschicht (20) als ein verbesserter Fowlwer-Nordheim-Injektor wirkt; und
eine auf der genannten vierschichtigen Sandwichplatte angeordnete leitende Schicht (12).

2. Ladungsspeicherstruktur nach Anspruch 1, enthaltend ferner getrennte Elektrodenmittel (14), welche an dem genannten Substrat und der genannten leitenden Schicht befestigt sind.

3. Ladungsspeicherstruktur nach Anspruch 1, worin die genannte leitende Schicht aus dotiertem Polysilikon besteht.

4. Ladungsspeicherstruktur nach Anspruch 1, worin die genannte leitende Schicht aus einem Metall wie Aluminium besteht.

5. Ladungsspeicherstruktur nach Anspruch 1, worin jede Schicht der genannten vierschichtigen Sandwichplatte eine Stärke in der Grössenordnung von 8—30 nm hat.

6. Ladungsspeicherstruktur nach Anspruch 1, enthaltend ferner Source- (24) und Drain-Bereiche (26), welche auf dem Substrat angeordnet sind, wobei die genannte vierschichtige Sandwichplatte und die genannte, zwischen der genannten Source und dem genannten Drain als ein Speicherbereich liegende, leitende Schicht eine Speichervorrichtung darstellen.

7. Ladungsspeicherstruktur nach Anspruch 6, enthaltend ferner erste und zweite Gatter (32), welche jeweils zwischen der genannten Source und dem genannten Speicherbereich und dem genannten Speicherbereich und dem genannten Drain angeordnet sind.

## Revendications

1. Structure de stockage de charge comprenant:
un substrat de silicium (10);
une superposition de quatre couches sur ladite couche de substrat de silicium, comprenant, dans l'ordre, une première couche de dioxyde de silicium (18), une première couche de dioxyde de silicium riche en silicium (22), une deuxième couche de dioxyde de silicium (16) et une deuxième couche de dioxyde de silicium riche en silicium (22), agissant comme un injecteur Fowler-Nordheim renforcé et stockant également des charges comme une région de piégeage profond, et la deuxième couche de dioxyde de silicium riche en silicium (20) agissant comme un injecteur Fowler-Nordheim renforcé; et
une couche conductrice (12) disposée sur ladite superposition de quatre couches.

2. Structure de stockage de charge suivant la revendication 1, comprenant en outre des électrodes séparées (14) fixées audit substrat et à ladite couche conductrice.

3. Structure de stockage de charge suivant la revendication 1, dans laquelle ladite couche conductrice et du polysilicium dopé.

4. Structure de stockage de charge suivant la revendication 1, dans laquelle ladite couche conductrice est un métal tel que l'aluminium.

5. Structure de stockage de charge suivant la revendication 1, dans laquelle chaque couche de ladite superposition de quatre couches a une épaisseur dans la plate de 8 à 30 nm.

6. Structure de stockage de charge suivant la revendication 1, comprenant en outre des régions de source (24) et de drain (26) disposées dans le substrat, ladite superposition de quatre couches et ladite couche conductrice placées entre ladite source et ledit drain comme région de stockage définissant ainsi un dispositif de mémoire.

7. Structure de stockage de charge suivant la revendication 6, comprenant en outre une première et une deuxième grilles (32) placées respectivement entre ladite source et ladite région de stockage et entre la dite région de stockage et ledit drain.

# FIG.1

# FIG.2